# EUROPÄISCHE PATENTSCHRIFT

(11) **EP 2 553 047 B1**
(45) Veröffentlichungstag und Bekanntmachung des Hinweises auf die Patenterteilung: **21.12.2016**
(21) Anmeldenummer: 11714935.1
(22) Anmeldetag: 31.03.2011
(51) Int. Cl.: C09K 11/06, H01L 31/0256, H01L 51/00, C09B 57/00, H01L 51/50

(54) **DOTIERSTOFF FÜR EINE LOCHLEITERSCHICHT FÜR ORGANISCHE HALBLEITERBAUELEMENTE UND VERWENDUNG DAZU**
DOPANT FOR A HOLE CONDUCTOR LAYER FOR ORGANIC SEMICONDUCTOR COMPONENTS, AND USE THEREOF
DOPANT POUR UNE COUCHE CONDUCTRICE DE TROUS POUR COMPOSANTS SEMI-CONDUCTEURS ORGANIQUES, ET SON UTILISATION

(30) Priorität: 31.03.2010 DE 102010013495
(43) Veröffentlichungstag der Anmeldung: 06.02.2013
(73) Patentinhaber: OSRAM OLED GmbH, 93049 Regensburg (DE)
(72) Erfinder: HARTMANN, David, 91056 Erlangen (DE); SZYSZKOWSKI, Sabine, 91462 Dachsbach (DE); KANITZ, Andreas, 91315 Höchstadt (DE); MALTENBERGER, Anna, 91359 Leutenbach (DE); SARFERT, Wiebke, 91074 Herzogenaurach (DE); SCHMID, Günter, 91334 Hemhofen (DE); WEMKEN, Jan Hauke, 90459 Nürnberg (DE)
(74) Vertreter: Epping - Hermann - Fischer
(86) Internationale Anmeldenummer: PCT/EP2011/001645
(87) Internationale Veröffentlichungsnummer: WO 2011/120709

(56) Entgegenhaltungen:
- WO-A1-03/022008
- WO-A1-2011/033023
- DE-A1-102008 051 737
- US-A1- 2009 035 675
- George W. Parshall: "Bis(1,1,1,5,5,5-Hexafluoro-2,4-Pentanedio nato)-Nickel(II) and -Cobalt(II): (Nickel and Cobalt Hexaftuoroacctylacctonates)", Wiley Inorganic Syntheses, Bd. 15 5. Januar 2007 (2007-01-05), Seiten 96-100, XP002648350, Weinheim DOI: 10.1002/9780470132463 ISBN: 9780470132463 Gefunden im Internet: URL:http://onlinelibrary.wiley.com/book/10 .1002/9780470132463 [gefunden am 2011-07-07]
- GARETH WILLIAMS J A ET AL: "Optimising the luminescence of platinum(II) complexes and their application in organic light emitting devices (OLEDs)", COORDINATION CHEMISTRY REVIEWS, ELSEVIER SCIENCE, AMSTERDAM, NL, Bd. 252, Nr. 23-24, 1. Dezember 2008 (2008-12-01), Seiten 2596-2611, XP025613200, ISSN: 0010-8545, DOI: DOI:10.1016/J.CCR.2008.03.014 [gefunden am 2008-04-07]
- LASKAR I R ET AL: "Highly efficient orange-emitting OLEDs based on phosphorescent platinum(II) complexes", POLYHEDRON, PERGAMON PRESS, OXFORD, GB, Bd. 24, Nr. 8, 2. Juni 2005 (2005-06-02), Seiten 881-888, XP025310122, ISSN: 0277-5387 [gefunden am 2005-06-02]
- VIGATO P A ET AL: "The evolution of beta-diketone or beta-diketophenol ligands and related complexes", COORDINATION CHEMISTRY REVIEWS, ELSEVIER SCIENCE, AMSTERDAM, NL, Bd. 253, Nr. 7-8, 1. April 2009 (2009-04-01), Seiten 1099-1201, XP026004375, ISSN: 0010-8545, DOI: DOI:10.1016/J.CCR.2008.07.013 [gefunden am 2008-07-30]

## Beschreibung

Die Erfindung betrifft neuartige metallorganische Materialien für Lochinjektionsschichten bei organischen elektronischen Bauelementen, insbesondere bei Licht emittierenden Bauelementen wie organischen Leuchtdioden (OLED) oder organischen Licht emittierenden elektrochemischen Zellen (OLEEC) oder organischen Feldeffekttransistoren oder organischen Solarzellen oder organischen Photodetektoren.

Zur Dotierung organischer Materialien mit Elektronenakzeptoren zur Erhöhung der Leitfähigkeit von Lochleiterschichten wurde in der Literatur vielfach demonstriert (siehe beispielsweise G. He, O. Schneider, D. Qin, X. Zhou, M. Pfeiffer, and K. Leo, Journal of Applied Physics 95, 5773 - 5777 (2004)).

In DE 102008051737 A1 werden Übergangsmetallkomplexe und deren Einsatz in organischen halbleitenden Materialien offenbart.

Durch Dotierung kann die Leitfähigkeit des Materials um Größenordnungen erhöht werden.

Es besteht grundsätzlicher Bedarf an weiteren, vor allem kostengünstigen Dotierstoffen für Lochtransportschichten.

Aufgabe der vorliegenden Erfindung ist es, weitere Dotierstoffe zum Einsatz in Lochleitermaterialien zur Verfügung zu stellen.

Lösung der Aufgabe und Gegenstand der Erfindung ist daher die Schaffung einer dotierten Lochleiterschicht zum Einsatz in organischen elektronischen Bauelementen, zumindest eine lochleitende Matrix und einen quadratisch-planaren einkernigen Übergangsmetallkomplex als Dotierstoff umfassend. Außerdem ist Aufgabe der vorliegenden Erfindung die Verwendung einer derartigen Lochleiterschicht anzugeben, sowie schließlich ein organisches elektronisches Bauelement.

Erfindungsgemäß wird eine Lochleiterschicht für organische elektronische Bauelemente angegeben, bei der in eine Lochleitermatrix ein Dotierstoff, umfassend einen einkernigen, quadratisch-planaren Übergangsmetallkomplex, der ein Zentralatom und Liganden umfasst, eingebracht ist, wobei der Übergangsmetallkomplex folgende Formel aufweist: 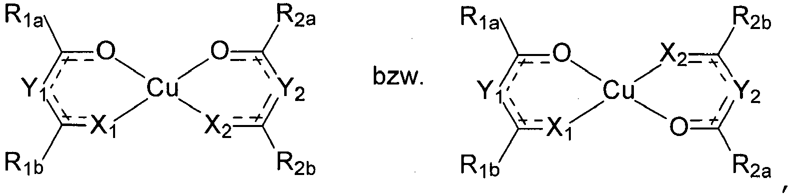 wobei:
Y₁, Y₂ bestehen unabhängig voneinander aus N, C-R oder C-H,
X₁ und X₂ sind unabhängig voneinander O oder N-R,
R, R_{1b} und R_{2b} sind unabhängig voneinander unverzweigte, verzweigte, kondensierte, ringförmige oder ganz oder teilweise substituierte C₁ - C₂₀-Alkylreste, substituierte oder unsubstituierte Aromaten und Heterocyclen,
R₁ₐ und R₂ₐ sind unabhängig voneinander ganz oder teilweise substituierte C₁ - C₂₀-Alkylreste, die Halogene enthalten oder entsprechen einer der Formeln 3.3a, 3.3b oder 3. 3c 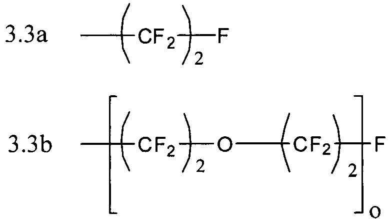 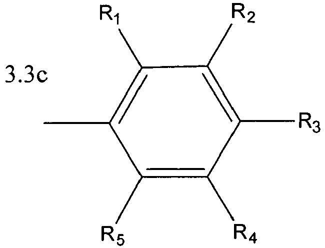 oder 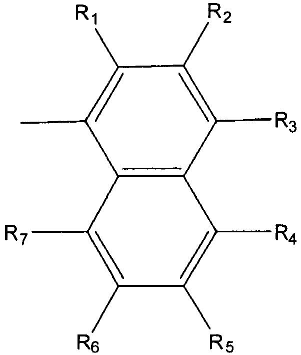 wobei
   in Formel 3.3b o = 1-5 und
   Formeln 3.3c ganz oder teilweise fluorierte Systeme sind, wobei R₁ bis R₇ unabhängig voneinander H oder F sind.

Nach einer Ausführungsform der Erfindung ist der Dotierstoff ein quadratisch-planarer einkerniger Übergangsmetallkomplex mit einem Kupferatom als Zentralatom.

Nach einer nicht erfindungsgemäßen Ausführungsform ist der Dotierstoff ein quadratisch-planarer einkerniger Übergangsmetallkomplex mit einem Palladium, Platin, Kobalt oder Nickelatom als Zentralatom.

Als quadratisch planar wird hier jede Komplexform bezeichnet, die von der tetraedrischen Komplexkonfiguration gemäß einer Kristallstrukturanalyse um mehr als die üblichen Messungenauigkeiten abweicht. In keinem Fall ist es auf eine flächige Anordnung der Liganden um das Zentralatom herum beschränkt.

Bevorzugt werden solche Liganden, die ein relativ tiefes LUMO gegenüber der lochleitenden Matrix haben, da diese Verbindungen sich in der Matrix durch eine höhere Lewis-Azidität auszeichnen. Damit ist dort der Dotiereffekt besonders ausgeprägt.

Aufgrund des quadratisch planaren Charakters können die Komplexe bei gleicher Summenformel in ihrer cis- oder trans-Form vorliegen. Im Allgemeinen, insbesondere bei kleinen Substituenten R dotieren beide Isomere gleich gut. Im Folgenden wird stellvertretend für beide Isomere nur das Trans-Isomere diskutiert.

Beispielhaft genannt für die gesamte Klasse der quadratisch planaren Übergangsmetallkomplexe ist die Klasse der einkernigen Komplexe mit Kupfer 2+ als Zentralatom.

Zur Festigung des quadratisch planaren Charakters der Verbindung werden verbrückte oder "zweizähnige" Liganden, wie vergleichsweise das Acetylacetonat, bevorzugt. Beim Kupfer als Zentralatom ist das natürlich wichtiger als beispielsweise beim Palladium, da dieses sowieso eine Tendenz zur Ausbildung quadratisch planarer Metallkomplexe zeigt.

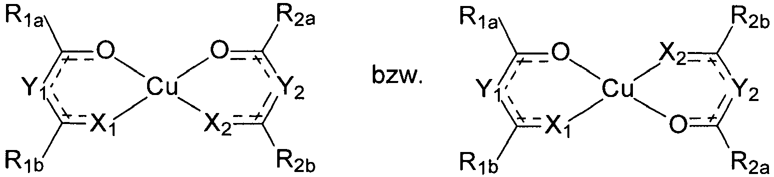

### Allgemeine Strukturformel I

Die Formel I zeigt ein Beispiel für die erfindungsgemäßen quadratisch planaren Kupfer (II) Komplexe. Bei gleicher Summenformel kann der Komplex in der cis- oder der trans-Form vorliegen.

In der Strukturformel I kann die Brücke Y₁ bzw. Y₂ unabhängig voneinander aus N bzw. C-R bestehen, wobei R ein beliebiger aliphatischer oder aromatischer Substituent sein kann, wie sie unten für R₁ₐ, R_{1b}, R₂ₐ und R_{2b} diskutiert werden.

Besonders bevorzugt ist die Brücke C-H. Diese wird in allen Ausführungsbeispielen verwendet.

X₁ und X₂ können unabhängig voneinander O oder N-R sein, wobei R für beliebige aliphatische oder aromatische Substituenten stehen kann, wie sie später beispielsweise für R₁ₐ, R_{1b}, R₂ₐ und R_{2b} diskutiert werden. Besonders bevorzugt ist X₁, X₂ = O. Hierbei werden mit Yi = C-R (i = 1 und/oder 2) Acetonylacetonat-Komplexe gebildet. Insbesondere die elektronenarmen Vertreter dieser Klasse bilden eine bevorzugte Klasse innerhalb der hier offenbarten Dotierungsstoffe für Lochleitermaterialien. Mit Xᵢ = N-R (i = 1 und/oder 2) werden Schiff-Base-Komplexe gebildet.

Die Substituenten R₁ₐ, R_{1b}, R₂ₐ und R_{2b} können unabhängig voneinander -Wasserstoff oder -Deuterium, Methyl-, Ethyl- verallgemeinert unverzweigte, verzweigte, kondensierte (Decahydronaphthyl-), ringförmige (Cyclohexyl-) oder ganz oder teilweise substituierte Alkylreste (C₁ - C₂₀) sein. Diese Alkylreste können Ethergruppen (Ethoxy-, Methoxy-, usw.), Ester-, Amid-, Carbonatgruppen etc. oder auch Halogene, insbesondere F enthalten. Im Sinne der Erfindung sind auch substituierte oder unsubstituierte aliphatische Ringe oder Ringsysteme, wie Cyclohexyl.

R₁ₐ, R_{1b}, R₂ₐ und R_{2b} sind nicht auf gesättigte Systeme beschränkt, sondern beinhalten auch substituierte oder unsubstituierte Aromaten wie Phenyl, Diphenyl, Naphthyl, Phenanthryl etc. oder Benzyl etc. Eine Zusammenstellung als Substituenten in Frage kommender Heterocyclen ist in Tabelle 1 dargestellt. Der Einfachheit halber ist nur der Grundkörper der Aromaten dargestellt. Prinzipiell kann dieser Grundkörper mit weiteren Resten R substituiert sein, die sich analog von den hier definierten Reste R₁ₐ, R_{1b}, R₂ₐ und R_{2b} ableiten lassen.

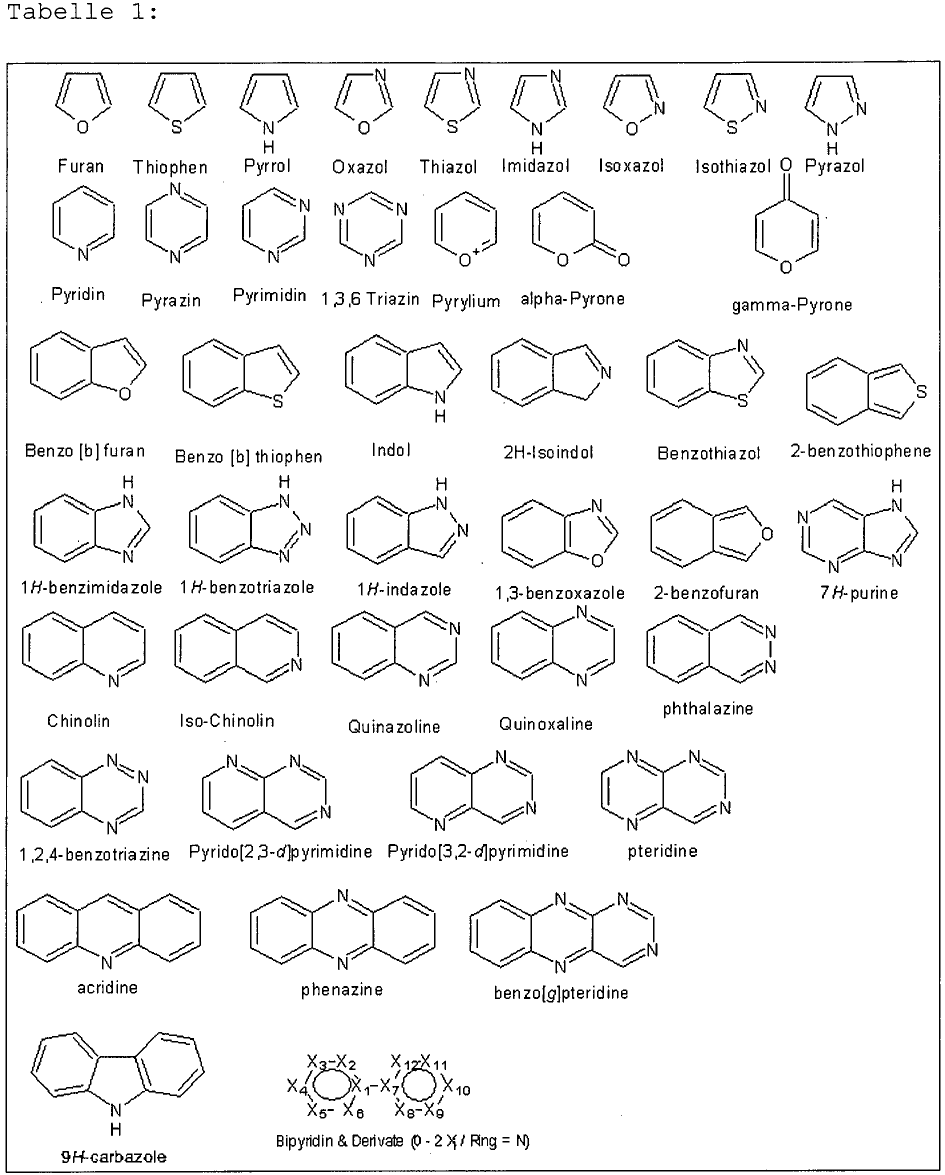

Die Tabelle 1 zeigt eine Auswahl substituierter oder unsubstituierter Heterozyklen, die als Reste R₁ₐ, R_{1b}, R₂ₐ und R_{2b} unabhängig voneinander in Frage kommen. Der Einfachheit halber ist nur die Grundeinheit dargestellt. Die Bindung an den Liganden kann an jeder bindungsfähigen Stelle des Grundkörpers erfolgen. Ganz besonders bevorzugt sich die elektronenarmen Varianten, wenn die Substituenten R₁ₐ, R_{1b}, R₂ₐ und R_{2b} elektronenziehende Substituenten mit Fluor direkt am Bindungskohlenstoff tragen (siehe Formeln 3.3a bis 3.3c). 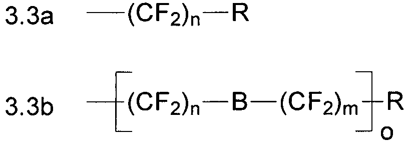 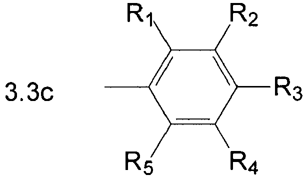 oder

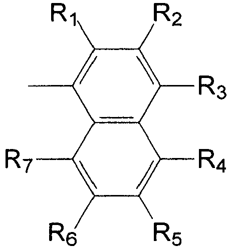

Formel III zeigt verschiedene Typen besonders bevorzugter Substituenten für die Reste R₁ₐ, R_{1b}, R₂ₐ und R_{2b}.

Dabei kann in Formel 3.3a n = 1 bis 20 sein, besonders bevorzugt ist n = 2 mit R = F. Ansonsten kann R wie die Reste R₁ₐ, R_{1b}, R₂ₐ und R_{2b} ausgewählt werden. Besonders bevorzugt sind hier aliphatische Ketten und/oder Aromaten.

In Formel 3.3b kann n, m, o unabhängig 0 bis 20 sein, besonders bevorzugt sind jedoch n = m = 2 und O im Bereich von 1 bis 5 mit R = F und B = O. Ansonsten kann R wie die Reste R₁ₐ, R_{1b}, R₂ₐ und R_{2b} ausgewählt werden. Besonders bevorzugt sind hier aliphatische Ketten und/oder Aromaten.

In Formel 3.3c können R₁ bis R₇ unabhängig voneinander wie die Reste R₁ₐ, R_{1b}, R₂ₐ und R_{2b} gewählt werden. Besonders bevorzugt sind jedoch ganz oder teilweise fluorierte Systeme mit R₁ bis R₇ unabhängig voreinander H oder F.

Erfindungsgemäß sind R, R_{1b} und R_{2b} unabhängig voneinander unverzweigte, verzweigte, kondensierte, ringförmige oder ganz oder teilweise substituierte C₁ - C₂₀-Alkylreste, substituierte oder unsubstituierte Aromaten und Heterocyclen.

Erfindungsgemäß sind R₁ₐ und R₂ₐ unabhängig voneinander ganz oder teilweise substituierte C₁ - C₂₀-Alkylreste, die Halogene enthalten oder entsprechen einer der Formeln 3.3a, 3.3b oder 3. 3c 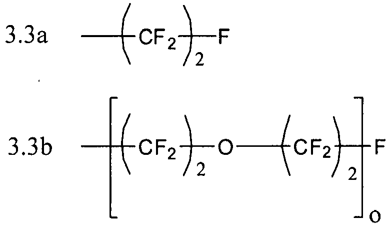 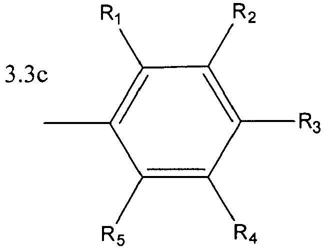 oder 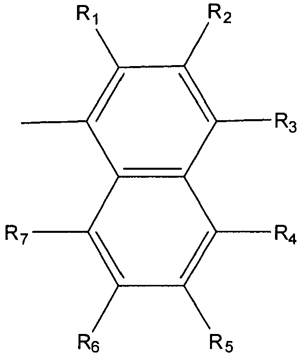 wobei
in Formel 3.3b o = 1-5 und
Formeln 3.3c ganz oder teilweise fluorierte Systeme sind, wobei R₁ bis R₇ unabhängig voneinander H oder F sind.

Auf die Synthesen der Komplexe wird nicht näher eingegangen, da diese sehr gründlich untersucht wurden. (Zitat: Buch "The Chemistry of Metal CVD, T.Kodas, M. Hampden Smith, VCH 1994, ISBN 3-527-29071-0, Seiten 178 - 192). Insbesondere werden diese Komplexe als Precursor für Kupfer-CVD (Chemical Vapor Deposition) in der Halbleiterindustrie genutzt. Viele leichtflüchtige Derivate sind deshalb kommerziell erhältlich.

Zur Herstellung der Lochtransportschicht werden die erfindungsgemäßen Materialien in einer Konzentration von 0.1 - 50%, vorzugsweise 5% - 30% in das Lochtransportmaterial eindotiert. Die Abscheidung der Schicht kann sowohl aus der Gasphase als auch Flüssigphase erfolgen.

Als Lochtransporter, die aus der Gasphase abgeschieden werden, kommen hierbei, aber nicht einschränkend in Frage:
N,N'-Bis(naphthalen-1-yl)-N,N'-bis(phenyl)-9,9-dimethyl-fluorene
N,N'-Bis(3-methylphenyl)-N,N'-bis(phenyl)-9,9-diphenyl-fluorene
N,N'-Bis(naphthalen-1-yl)-N,N'-bis(phenyl)-9,9-diphenyl-fluorene
N,N'-Bis(naphthalen-1-yl)-N,N'-bis(phenyl)-2,2-dimethylbenzidine
N,N'-Bis(3-methylphenyl)-N,N'-bis(phenyl)-9,9-spirobifluorene
2,2',7,7'-Tetrakis(N,N-diphenylamino)-9,9'-spirobifluorene
N, N'-Bis(naphthalen-1-yl)-N,N'-bis(phenyl)-benzidine
N, N'-Bis(naphthalen-2-yl)-N,N'-bis(phenyl)-benzidine
N, N'-Bis(3-methylphenyl)-N,N'-bis(phenyl)-benzidine
N,N'-Bis(3-methylphenyl)-N,N'-bis(phenyl)-9,9-dimethyl-fluorene
N,N'-Bis(naphthalen-l-yl)-N,N'-bis(phenyl)-9,9-spirobifluorene
Di-[4-(N,N-ditolyl-amino)-phenyl]cyclohexane
2,2',7,7'-tetra(N, N-di-tolyl)amino-spiro-bifluorene
9,9-Bis[4-(N,N-bis-biphenyl-4-yl-amino)phenyl]-9H-fluorene
2,2',7,7'-Tetrakis[N-naphthalenyl(phenyl)-amino]-9,9-spirobifluorene
2,7-Bis[N,N-bis(9,9-spiro-bifluorene-2-yl)-amino]-9,9-spirobifluorene
2,2'-Bis[N,N-bis(biphenyl-4-yl)amino]-9,9-spirobifluorene N, N'-bis(phenanthren-9-yl)-N,N'-bis(phenyl)-benzidine
N, N,N',N'-tetra-naphthalen-2-yl-benzidine
2,2'-Bis(N,N-di-phenyl-amino)-9,9-spirobifluorene
9,9-Bis[4-(N,N-bis-naphthalen-2-yl-amino)phenyl]-9H-fluorene
9,9-Bis[4-(N,N'-bis-naphthalen-2-yl-N,N'-bis-phenyl-amino)-phenyl]-9H-fluorene
Titanium oxide phthalocyanine
Copper phthalocyanine
2,3,5,6-Tetrafluoro-7,7,8,8,-tetracyano-quinodimethane
4,4',4"-Tris(N-3-methylphenyl-N-phenyl-amino)-triphenylamine
4,4',4" -Tris(N-(2-naphthyl)-N-phenyl-amino)triphenylamine
4,4',4" -Tris(N-(1-naphthyl)-N-phenyl-amino)triphenylamine
4,4',4" -Tris(N,N-diphenyl-amino)triphenylamine
Pyrazino[2,3-f][1,10]phenanthroline-2,3-dicarbonitrile
N, N,N' ,N' -Tetrakis(4-methoxyphenyl)benzidine
2,7-Bis[N,N-bis(4-methoxy-phenyl)amino]-9,9-spirobifluorene
2,2'-Bis[N,N-bis(4-methoxy-phenyl)amino]-9,9-spirobifluorene
N, N'-di(naphthalen-2-yl)-N,N'-diphenylbenzene-1,4-diamine
N,N'-di-phenyl-N,N'-di-[4-(N,N-di-tolyl-amino)phenyl]benzidine
N,N'-di-phenyl-N,N'-di-[4-(N,N-di-phenyl-amino)phenyl]benzidin

Diese monomolekularen Lochtransportmaterialien können auch aus der Flüssigphase abgeschieden werden oder zu den unten genannten polymeren Materialien hinzugemischt werden. Die Flimbildungseigenschaften werden verbessert, wenn nieder-molekulare und polymere Materialien gemischt werden. Die Mischungsverhältnisse liegen zwischen 0 - 100 %.

Polymere Lochtransporter, die vornehmlich aus der Flüssi-phase abgeschieden werden, sind beispielhaft, aber nicht einschränkend: PEDOT, PVK, PTPD, P3HT und PANI (PVK = poly(9-vinylcarbazole), PTPD = poly(N,N'-bis(4-butylphenyl)-N,N'-bis(phenyl)-benzidine), P3HT = poly(3-hexylthiophene) and PANI = polyaniline) siehe unten,

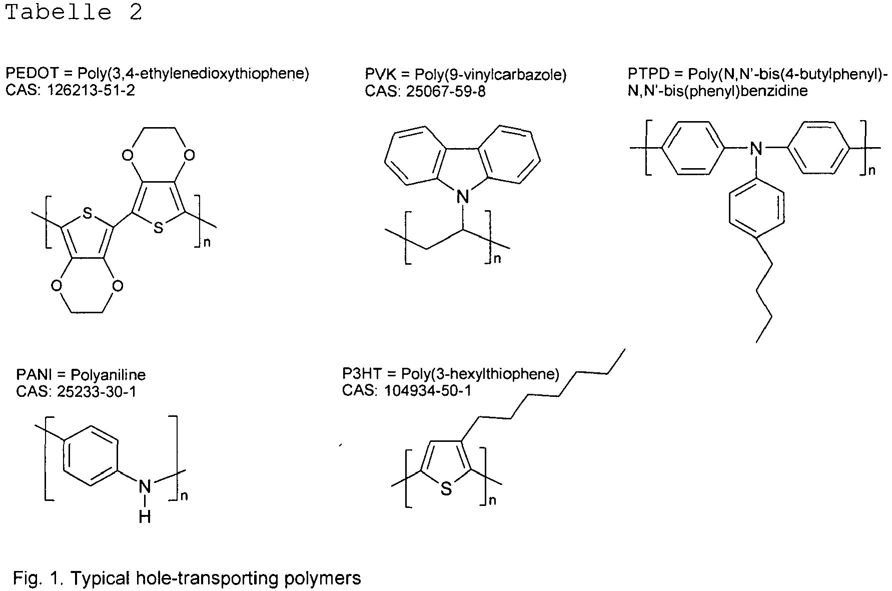

Tabelle 2 zeigt typische lochtransportierende Polymere, die bevorzugt aus der Flüssigphase abgeschieden werden.

Die genannten Materialien können auch als beliebige Mischungen vorliegen.

Als Lösungsmittel kommen die gängigen organischen Lösungs-mittel in Frage, vornehmlich jedoch Chlorbenzol, Chloroform, Benzol, Anisol,Toluol, Xylol, THF, Methoxypropylacetat, Phentole, Methylethylketon, N-Methylpyrrolidon, gamma-Butyrolacton etc.

Formal lässt sich die Dotierung durch Koordination von 1 - 2 Lochleitermolekülen (hier NPB) in die axialen Positionen des quadratisch planaren Übergangsmetall-Komplexes vorstellen.

Am Beispiel der Kupfer 2+-Komplexe demonstriert, sieht das so aus:

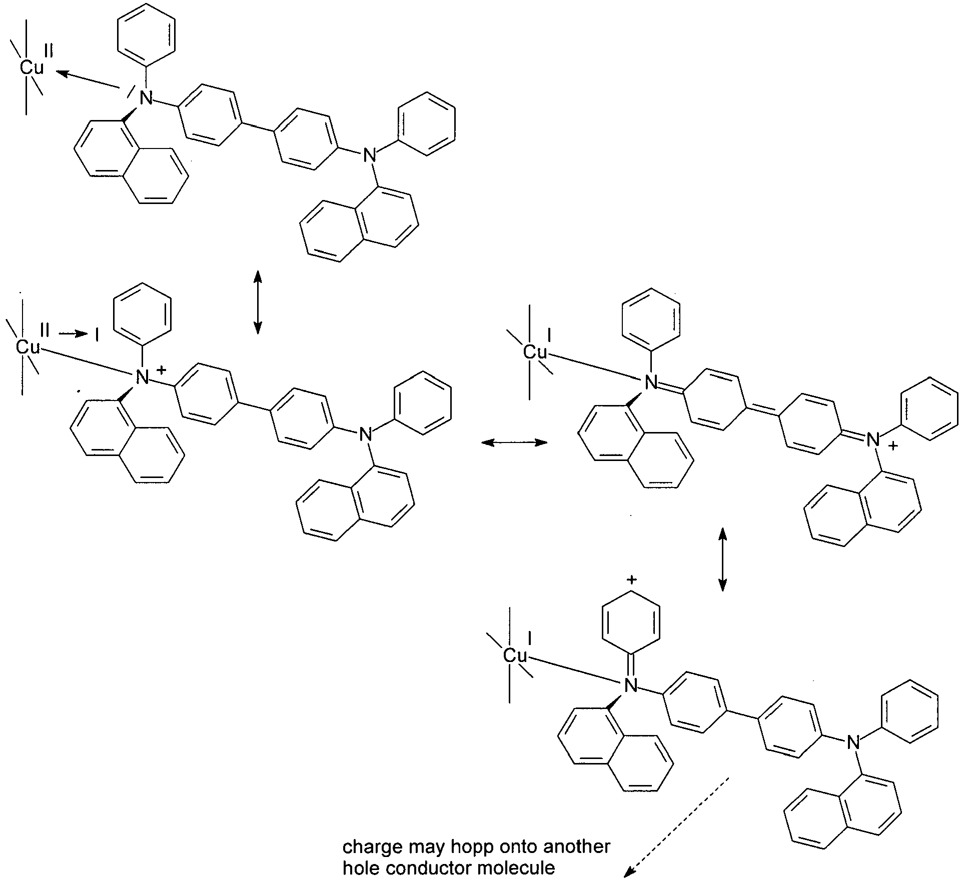

Durch die hier erstmals gezeigten Dotierstoffe in Form quadratisch planarer Übergangsmetallkomplexe können billige und leicht zugängliche Verbindungen erstmals in diese Technik der Dotierstoffzugabe eingeführt werden.

Beispielsweise sind viele der Kupfer 2+-Verbindungen leicht zugänglich, da sie bei Kupfer-CVD-Verfahren in der Halbleiterindustrie benutzt werden. Zudem sind die Herstellungsverfahren gut ausgearbeitet, die Dotierstoffe gehen oft günstig her, die damit gefertigten Bauteile haben ein neutrales Erscheinungsbild im ausgeschalteten Zustand und schließlich eignen sich die Materialien für die Abscheidung der dotierten Lochleiter aus der Gas- oder Flüssigphase.

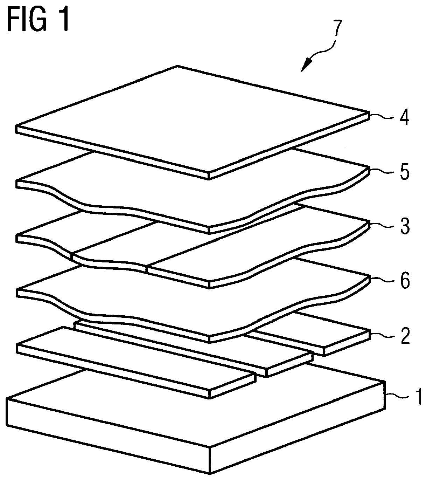

Im folgenden wird die Erfindung noch anhand von drei Ausführungsbeispielen, zwei Vergleichsbeispielen und Figuren 1 bis 7 näher erläutert:
Figur 1 zeigt den Aufbau einer OLEEC schematisch.

Eine OLED 7 ist in den meisten Fällen durch ein einfaches Einbringen einer organischen Schicht 3 zwischen zwei organischen Hilfsschichten, einer Elektronentransportschicht 5 und einer Lochtransportschicht 6 aufgebaut. Dieser organisch aktive Teil der OLED, umfassend die Schichten 3, 5 und 6 wird dann zwischen zwei Elektroden 2 und 4 gebracht. Beim Anlegen von Spannung tritt Licht aus. Die bevorzugt eine aktive emittierende Schicht 3 einer OLED besteht aus einer Matrix, in die eine emittierende Spezies eingebettet ist. Schicht 3 umfasst auch einen Schichtstapel, beispielsweise für den Emitter rot, grün, blau.

Auf dem transparenten Substrat 1 befindet sich die untere transparente Elektrodenschicht 2, beispielsweise die Anode. Danach kommt die Lochtransportschicht 6, deren Dotierung Gegenstand der vorliegenden Erfindung ist. Auf der, der Lochleiterschicht gegenüberliegenden Seite der organischen aktiven Schicht befindet sich die Elektroneninjektionsschicht 5, auf der die obere Elektrode 4, beispielsweise eine Metallelektrode, liegt.

Die OLED 7 ist in der Regel verkapselt, was hier nicht gezeigt ist.

### Beispiel 1

Die fünf bereits erwähnten Kupfer-Acetylacetonate für die Dotierung der Lochleiterschicht wurden zwecks Aufreinigung und Untersuchung des Sublimationspunktes in einer Sublimationsanlage bei einem Basisdruck kleiner 1.0E-5 mbar sublimiert. Diese Sublimationen ergaben die in folgender Tabelle aufgelisteten Ergebnisse bezüglich Sublimationstemperatur und Farbveränderung der Materialien:

**Tab. 4: Sublimationspunkte und Farbeigenschaften der 5 Kupfer-Acetylacetonate**

| **Material** | **Ausgangsfarbe** | **Sublimationsbereich** | **Farbe nach Sublimation** |
|---|---|---|---|
| Cu(acac)2* | Blau-lila | 110-120 °C | Blau-lila |
| Cu(tfac)₂ | Lila | 95-100 °C | Lila |
| Cu(hfac)₂ | Dunkel-grün | 70 °C @ 1E-2mbar | Grün-schwarz |
| Cu(fod)₂ | Grün | 60-70 °C | Grün |
| Cu(dpm)2* | lila | 70-80 °C | Lila |

| | | | |
|---|---|---|---|
| * Vergleichsbeispiel | | | |

Diese Versuche zeigen, dass die beiden Materialien Cu(acac)₂ als Vergleichsbeispiel und Cu(tfac)₂ als erfindungsgemäßes Ausführungsbeispiel für die Vakuumprozessierung gut geeignet sind.

Weiterhin wurde in diesem Zusammenhang die Löslichkeit der fünf Kupfer-Acetylacetonate in THF, Toluol und Chlorbenzol untersucht um eine mögliche Lösungsprozessierung zu klären. Hierbei zeigte sich, dass alle Materialien in den genannten Lösungsmittel in kurzer Zeit vollständig lösbar sind und damit auch für eine Lösungsprozessierung in Frage kommen.

Beispielsweise wurden aus Chlorbenzol Lösungen von Cu(hfac)₂ als erfindungsgemäßes Ausführungsbeispiel als Dotierstoff erfolgreich, also mit signifikantem Dopingeffekt, eingesetzt. Ebenso konnte das erfindungsgemäße Cu(fod)₂ aus Lösung in Chlorbenzol getestet werden, wobei wiederum ein signifikanter Dotierungseffekt zu beobachten war. Die Lösungsmittelkonzentrationen betrugen in beiden Fällen etwa 1,5% und die Schichtdicke 90 bis 100 nm.

### Beispiel 2

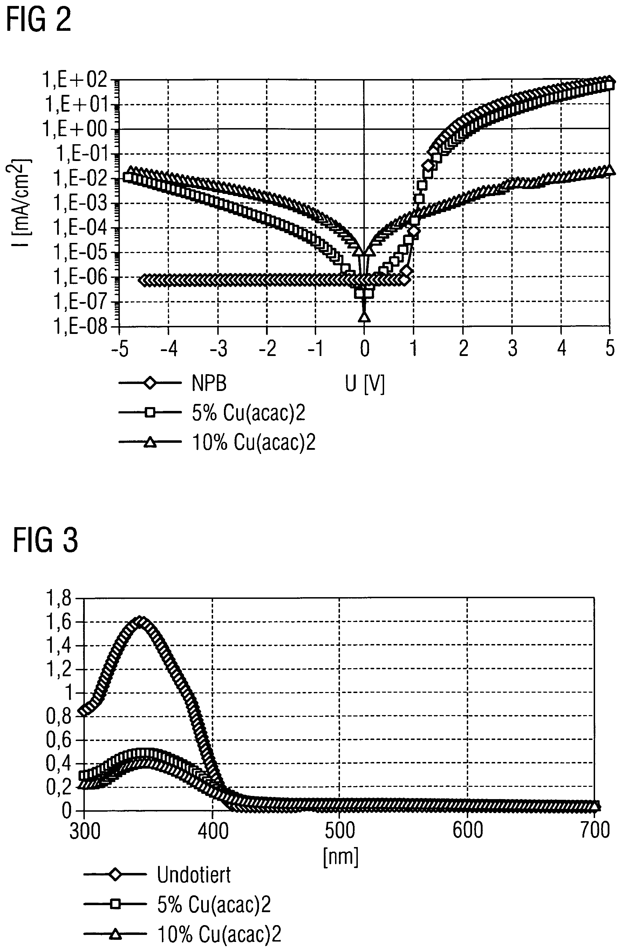

Auf einer ITO (Indium-tin-oxide = Zinnoxid dotiertes Indiumoxid) Elektrode (untere, transparente Elektrode 2) wurde durch thermisches Verdampfen eine 200 nm dicke Schicht des Lochleiters NPB (= Bis-N,N,N',N'-(naphthyl-phenyl)benzidin) abgeschieden. Als Gelegenelektroden diente eine 150 nm dicke Aluminiumschicht (obere Elektrode 4). Ein 4 mm² großes Bauelement ergab die durch schwarze Rauten markierte Strom-Spannungs-Kennlinie (IV-Kennlinie) die Referenzlinie, die in Figur 2 gezeigt ist.

In zwei weiteren Experimenten wurde der nicht erfindungsgemäße Dotierstoff Cu(acac)₂ in Konzentrationen von 5% und 10% relativ zur Verdampfungsrate in NPB eindotiert. Substrate, Schichtdicken und Größe der Bauelemente waren wie im ersten Experiment erwähnt.

Das Bauelement mit 5% Konzentration ergab dabei die mit Quadraten gekennzeichnete Kennlinie und das Bauelement mit 10% Konzentration die durch Dreiecke markierte Kennlinie.

Figur 2 zeigt die graphische Zusammenfassung der Versuche, also die Strom-Spannungskennlinien von NPB (Referenzlinie) und NPB dotiert mit dem nicht erfindungsgemäßen Cu(acac)₂.

Für beide Konzentrationen kann gezeigt werden, dass die Dotierung einen Effekt auf die IV-Kennlinie hat.

Das asymmetrische Verhalten mit einem leichten Anstieg für negative Spannungen der 5% Kennlinie (Quadrate) zeigt, dass die Dotierung einen Effekt im Bauelement verursacht, die gewählte Konzentration aber nicht ausreicht. Das symmetrische Verhalten der 10% Kennlinie (Dreiecke) ist ein typisches Anzeichen für eine erfolgreiche Dotierung, aber es ist kein deutlicher Anstieg der Stromdichte speziell für positive Spannungen zu erkennen.

### Beispiel 3

Während der Experimente aus Beispiel 2 wurden die undotierte NPB und die mit dem nicht erfindungsgemäßen Cu(acac)₂ dotierten NPB Schichten zusätzlich jeweils auf einer Quarzglasscheibe abgeschieden. Diese Proben besitzen keine elektrischen Kontakte und dienen nur zur Messung von Absorptions- und Emissionsspektra der einzelnen Schichten.

Die reine NPB Schicht (Referenzlinie) ergab dabei die in Figur 3 gezeigten mit schwarzen Rauten markierten Kennlinien für Absorptions- bzw. Photo-Luminescence-Spektra. Die Proben mit 5% eindotiertem nicht erfindungsgemäßem Cu(acac)₂ ergaben die mit Quadraten gezeigten Spektra und die Proben mit 10% eindotiertem nicht erfindungsgemäßem Cu(acac)₂ ergaben die mit Dreiecken markierten Spektra.

Im Vergleich der Absorptionsspektra (Fig. 3) zeigt sich, dass reines NPB eine um den Faktor 3 höhere Absorption im Absorptionsmaximum (344nm) aufweißt. Die mit dem nicht erfindungsgemäßen Cu(acac)₂ dotierten Schichten weisen dafür im Bereich 410-440 nm eine zum reinen NPB erhöhte Absorption auf. Dies weist auf die Bildung eines Charge-Transfer-Komplexes und damit auf einen Dotiereffekt hin. Im Absorptionsspektrum weißt die 5% Probe eine etwas höhere Absorption auf als die 10% Probe, aber insgesamt liegen beide sehr nahe zusammen und weisen den in Beispiel 2 anhand der elektrischen Kennlinien gezeigten Dotiereffekt auf.

Figur 3 zeigt die Absorptionsspektra von NPB und NPB dotiert mit dem nicht erfindungsgemäßen Cu(acac)₂.

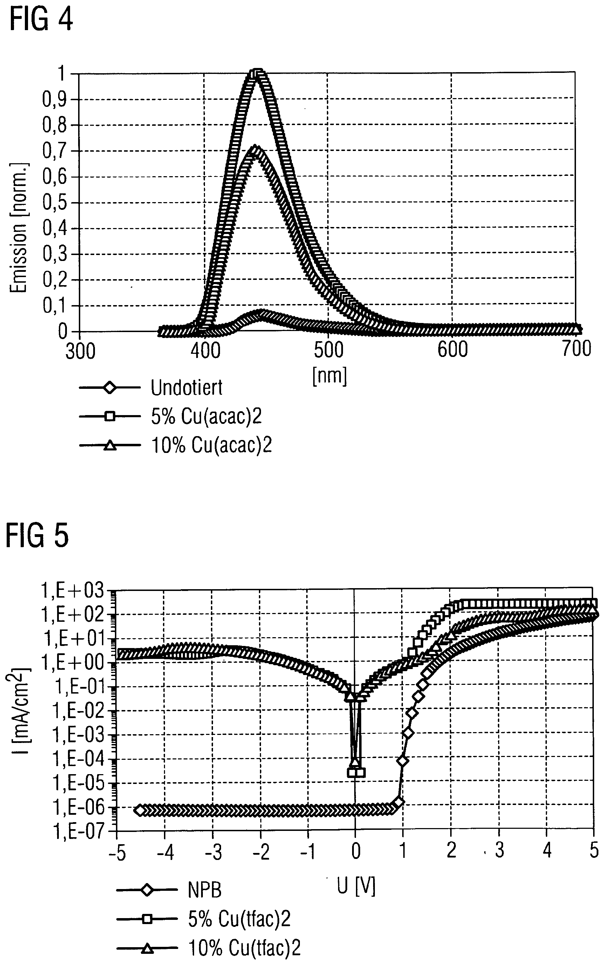

Im Vergleich der PL-Spektra (Fig. 4) zeigt sich, dass die mit dem nicht erfindungsgemäßen Cu(acac)₂ dotierten Proben eine höhere Emission aufweisen als die reine NPB Probe. Gleichzeitig ist ein minimaler Shift der Emission hin zu niedrigern Wellenlängen zu beobachten. Reines NPB emittiert bei 444nm während die 5% bzw. 10% dotierten Schichten bei 440nm bzw. 438nm emittieren. Die Verschiebung der Emission aufgrund einer Dotierung ist wiederum anhand des Charge-Transfer-Komplexes zu erklären. Was hier allerdings neu ist, ist der Emission verstärkende Effekt des Kupfer-Acetylacetonates. Eine Verstärkung ist in sofern unüblich, als dass Dopanten eigentlich als Emissionshemmer (Quencher) bekannt sind.

### Beispiel 4

Analog zu Beispiel 2 wurde in zwei weiteren Experimenten der erfindungsgemäße Dotierstoff Cu(tfac)₂ in Konzentrationen von 5% und 10% relativ zur Verdampfungsrate in NPB eindotiert. Substrate, Schichtdicken und Größe der Bauelemente waren wie im Beispiel 1 erwähnt.

Das Bauelement mit 5% Konzentration ergab dabei die mit Quadraten gekennzeichnete Kennlinie und das Bauelement mit 10% Konzentration die durch Dreiecke markierte Kennlinie. Die mit schwarzen Rauten markierte Kennlinie zeigt wieder das Referenzbauteil aus reinem NPB.

Für beide Konzentrationen ist ein Anstieg der Stromdichte zu sehen sowie ein symmetrie-ähnliches Verhalten, was beides einen vorhandenen Dotiereffekt zeigt. Der waagerechte Bereich der 5% Linie ist hierbei keine Strombegrenzung seitens des Bauteils sondern ist die Compliance (Messbegrenzung) des Messgerätes. Die höhere Stromdichte der 5% Probe gegenüber der 10% Probe zeigt, dass das Optimum der Dotierstoffkonzentration unter 10% liegt. Die optimale Konzentration muss aber nicht zwingend zwischen 5% und 10% liegen, sondern kann auch noch tiefer sein und kann dadurch einen noch größeren Dotiereffekt hervorrufen.

Der Vergleich der Experimente aus Beispiel 2 mit dem nicht erfindungsgemäßen Cu(acac)₂ und diesem Beispiel mit dem erfindungsgemäßen Cu(tfac)₂ zeigt, dass eine Fluorierung des Liganden im Komplex den Dotiereffekt verbessert. Es ist daher anzunehmen, dass eine noch weitere Verbesserung mit dem erfindungsgemäßen Cu(hfac)₂ möglich ist. Wie in Beispiel 1 bereits erwähnt kommt das erfindungsgemäße Cu(hfac)₂ allerdings nicht für die Vakuumprozessierung, sondern nur für eine Lösungsprozessierung in Frage (siehe folgende Beispiele).

Figur 5 zeigt die Strom-Spannungskennlinien von NPB und NPB dotiert mit dem erfindungsgemäßen Cu(tcac)₂.

### Beispiel 5

Während der Experimente aus Beispiel 4 wurden die undotierte NPB und die mit dem erfindungsgemäßen Cu(tfac)₂ dotierten NPB Schichten zusätzlich jeweils auf einer Quarzglasscheibe abgeschieden. Diese Proben besitzen keine elektrischen Kontakte und dienen nur zur Messung von Absorptions- und Emissionsspektra der einzelnen Schichten.

Die reine NPB Referenz-Schicht ergab dabei die mit schwarzen Rauten markierten Kennlinien für Absorptions- bzw. Photo-Luminescence-Spektra Die Proben mit 5% eindotiertem erfindungsgemäßem Cu(tfac)₂ ergaben die mit Quadraten gezeigten Spektra und die Proben mit 10% eindotiertem erfindungsgemäßem Cu(tfac)₂ ergaben die mit Dreiecken markierten Spektra.

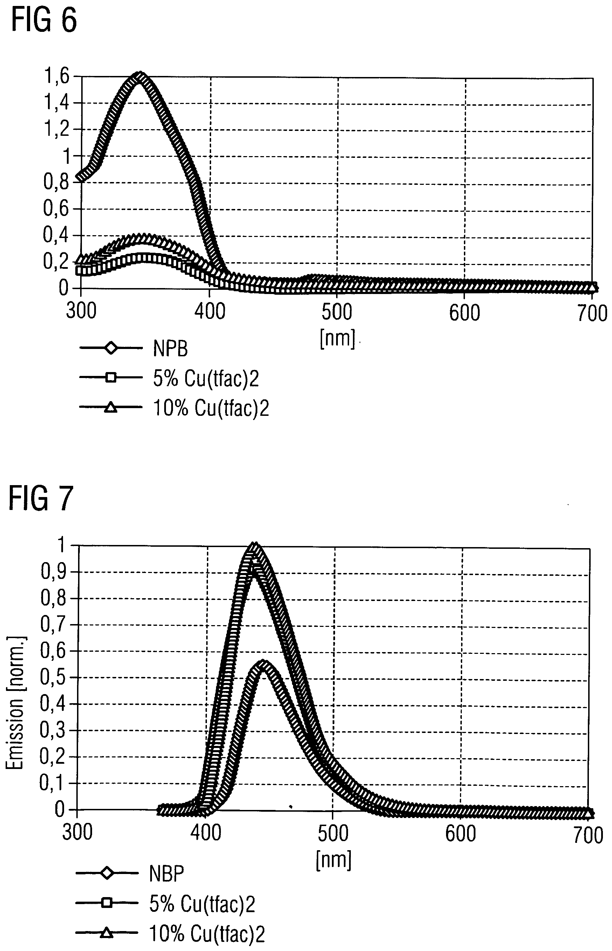

Im Vergleich der Absorptionsspektra (Fig. 6) zeigt sich, dass reines NPB eine um den Faktor 3-4 höhere Absorption im Absorptionsmaximum (344nm) aufweißt. Die mit dem erfindungsgemäßen Cu(tfac)₂ dotierten Schichten weisen dafür im Bereich 410-440 nm eine zum reinen NPB erhöhte Absorption auf, welche dann zwischen 450-550nm wieder niedriger als reines NPB ist. Dies weist auf die Bildung eines Charge-Transfer-Komplexes und damit auf einen Dotiereffekt hin. Im Absorptionsspektrum weist die 10% Probe eine etwas höhere Absorption auf als die 5% Probe, aber insgesamt liegen beide deutlich tiefer als reines NPB und weisen den in Beispiel 4, anhand der elektrischen Kennlinien gezeigten, Dotiereffekt auf. Der Dotiereffekt in Beispiel 4 ist für die 10% Probe geringer und auch hier wird dies durch den geringeren Abfall in der Absorption im Vergleich zur 5% Probe deutlich.

Im Vergleich der PL-Spektra (Fig. 7) zeigt sich, dass die mit dem erfindungsgemäßen Cu(tfac)₂ dotierten Proben ebenfalls wie in Beispiel 3 eine höhere Emission aufweisen als die reine NPB Probe. Gleichzeitig ist auch hier ein Shift der Emission hin zu niedrigern Wellenlängen zu beobachten. Reines NPB emittiert bei 444nm während die 5% bzw. 10% dotierten Schichten bei 436nm bzw. 434nm emittieren. Die Verschiebung der Emission aufgrund einer Dotierung ist wiederum anhand des Charge-Transfer-Kom-plexes zu erklären. Was auch hier wiederum neu ist, ist der Emission verstärkende Effekt des Kupfer-Acetylacetonates. Eine Verstärkung ist wie bereits erwähnt eigentlich unüblich, als dass Dopanten eigentlich als Emissionshemmer (Quencher) bekannt sind.

Figur 6 zeigt die Absorptionsspektra von NPB und NPB dotiert mit dem erfindungsgemäßen Cu(tfac)₂ in zwei Konzentrationen

Figur 7 schließlich zeigt PL-Spektra von NPB und NPB dotiert mit dem erfindungsgemäßen Cu(tfac)₂.

Lumineszenz (cd/m²), Effizienz (cd/A) und Lebensdauer (h) organischer elektronische Bauelemente wie insbesondere von organischen Leuchtdioden (Fig.1) hängen stark von der Exzitonendichte in der lichtemittierenden Schicht und der Qualität der Ladungsträgerinjektion ab und werden unter anderem auch durch diese limitiert. Diese Erfindung beschreibt eine Lochinjektionsschicht, bestehend aus quadratisch planaren einkernigen Übergangsmetall-Komplexen, wie beispielsweise von Kupfer 2+-Komplexen, die in eine lochleitende Matrix eingebettet werden.

## Patentansprüche

1. Lochleiterschicht für organische elektronische Bauelemente, bei der in eine Lochleitermatrix ein Dotierstoff, umfassend einen einkernigen, quadratisch-planaren Übergangsmetallkomplex, der ein Zentralatom und Liganden umfasst, eingebracht ist, wobei der Übergangsmetallkomplex folgende Formel aufweist: 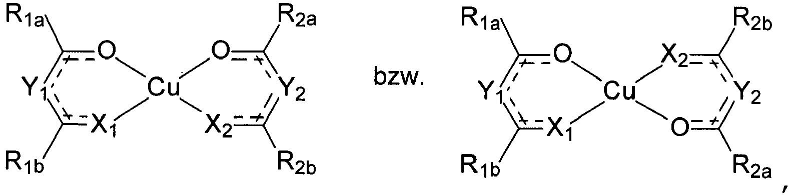 wobei:
Y₁, Y₂ bestehen unabhängig voneinander aus N, C-R oder C-H,
X₁ und X₂ sind unabhängig voneinander O oder N-R, R, , R_{1b}, und R_{2b} sind unabhängig voneinander unverzweigte, verzweigte, kondensierte, ringförmige oder ganz oder teilweise substituierte C₁ - C₂₀-Alkylreste, substituierte oder unsubstituierte Aromaten und Heterocyclen,
R₁ₐ und R₂ₐ sind unabhängig voneinander ganz oder teilweise substituierte C₁ - C₂₀-Alkylreste, die Halogene enthalten oder entsprechen einer der Formeln 3.3a, 3.3b oder 3.3c 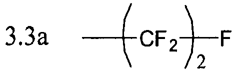 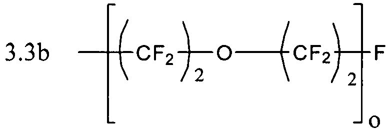 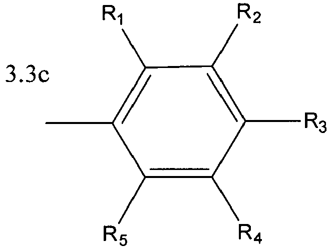 oder 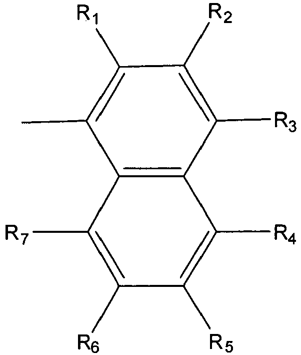 wobei
in Formel 3.3b o = 1-5 und
Formeln 3.3c ganz oder teilweise fluorierte Systeme sind, wobei R₁ bis R₇ unabhängig voneinander H oder F sind.

2. Lochleiterschicht nach Anspruch 1, wobei die Liganden ausgewählt sind aus der Gruppe Trifluoroacetylacetonat (tfac), Hexafluoroacetylacetonat (hfac) und 6,6,7,7,8,8,8-heptafluoro-2,2-dimethyl-3,5-octandionat(fod).

3. Verwendung einer Lochleiterschicht nach einem der vorstehenden Ansprüche 1 bis 2 in einem organischen elektronischen Bauelement.

4. Organisches elektronisches Bauelement mit einer dotierten Lochleiterschicht, wobei der Dotierungsstoff einen Übergangsmetallkomplex umfasst, der einkernig und quadratisch-planar ist und folgende Formel aufweist: 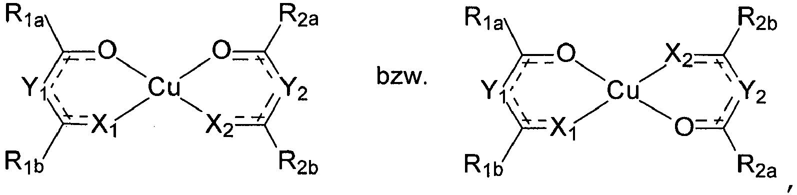 wobei:
Y₁, Y₂ bestehen unabhängig voneinander aus N, C-R oder CH X₁ und X₂ sind unabhängig voneinander O oder N-R, R, R_{1b}, und R_{2b} sind unabhängig voneinander unverzweigte, verzweigte, kondensierte, ringförmige oder ganz oder teilweise substituierte C₁ - C₂₀-Alkylreste , substituierte oder unsubstituierte Aromaten und Heterocyclen,
R₁ₐ und R₂ₐ sind unabhängig voneinander ganz oder teilweise substituierte C₁ - C₂₀-Alkylreste, die Halogene enthalten oder entsprechen einer der Formeln 3.3a, 3.3b oder 3.3c 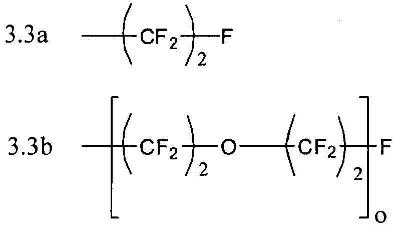 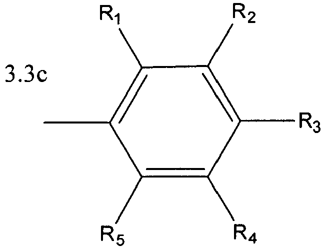 oder 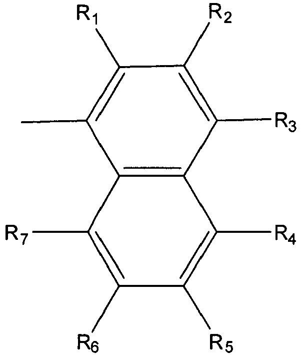 wobei
in Formel 3.3b o = 1-5 und
Formeln 3.3c ganz oder teilweise fluorierte Systeme sind, wobei R₁ bis R₇ unabhängig voneinander H oder F sind.

5. Bauelement nach Anspruch 4, das ein selbstemittierendes Bauelement ist.

## Claims

1. Hole conductor layer for organic electronic components, in which a dopant comprising a mononuclear square-planar transition metal complex comprising a central atom and ligands has been introduced into a hole conductor matrix, where the transition metal complex has the following formula: 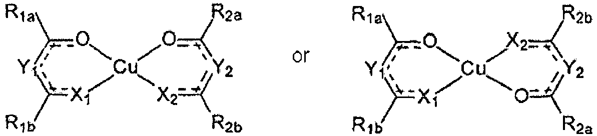 where:
Y₁, Y₂ each independently consist of N, C-R or C- H,
X₁ and X₂ are each independently O or N-R, R, R_{1b} and R_{2b} are each independently unbranched, branched, fused, cyclic or fully or partly substituted C₁-C₂₀-alkyl radicals, substituted or unsubstituted aromatics and heterocycles,
R₁ₐ and R₂ₐ are each independently fully or partly substituted C₁-C₂₀-alkyl radicals which contain halogens
or correspond to one of the formulae 3.3a, 3.3b or 3.3c 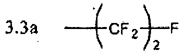 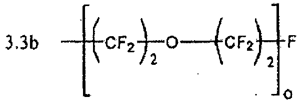 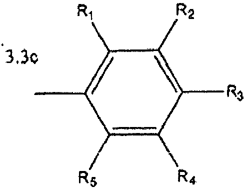 or 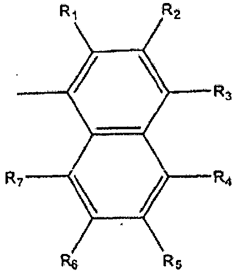 where
in formula 3.3b o = 1-5 and
formulae 3.3c are fully or partly fluorinated systems, where R₁ to R₇ are each independently H or F.

2. Hole conductor layer according to Claim 1, wherein the ligands are selected from the group of trifluoroacetylacetonate (tfac), hexafluoroacetylacetonate (hfac) and 6,6,7,7,8,8,8-heptafluoro2,2-dimethyl-3,5-octanedionate (fod).

3. Use of a hole conductor layer according to either of the preceding Claims 1 and 2 in an organic electronic component.

4. Organic electronic component having a doped hole conductor layer, wherein the dopant comprises a transition metal complex which is mononuclear and square-planar and has the following formula: 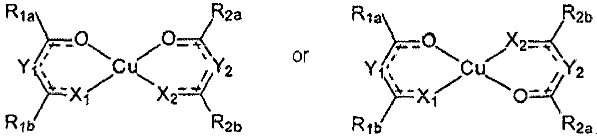 where:
Y₁, Y₂ each independently consist of N, C-R or CH,
X₁ and X₂ are each independently O or N-R, R, R_{1b} and R_{2b} are each independently unbranched, branched, fused, cyclic or fully or partly substituted C₁-C₂₀-alkyl radicals, substituted or unsubstituted aromatics and heterocycles,
R₁ₐ and R₂ₐ are each independently fully or partly substituted C₁-C₂₀-alkyl radicals which contain halogens or correspond to one of the formulae 3.3a, 3.3b or 3.3c 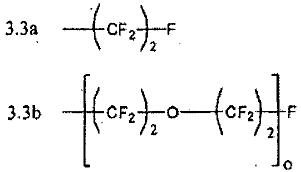 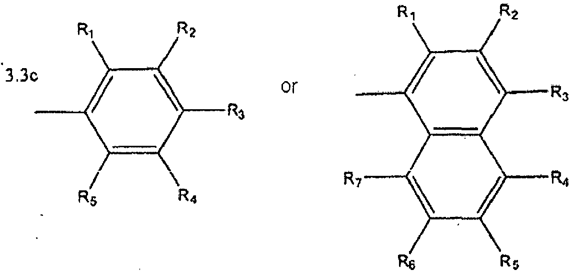 where
in formula 3.3b o = 1-5 and
formulae 3.3c are fully or partly fluorinated systems, where R₁ to R₇ are each independently H or F.

5. Component according to Claim 4, which is a self-emitting component.

## Revendications

1. Couche conductrice de trous pour composants organiques électroniques, dans laquelle une substance de dopage, comprenant un complexe de métal de transition mononucléaire, quadratique plan, qui comprend un atome central et des ligands, est introduite dans une matrice conductrice de trous, le complexe de métal de transition présentant les formules suivantes : 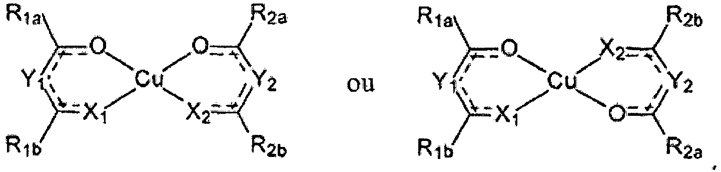 dans lesquelles :
Y₁, Y₂ représentent, indépendamment l'un de l'autre, N, C-R ou C-H,
X₁ et X₂ représentent, indépendamment l'un de l'autre, O ou N-R,
R, R_{1b} et R_{2b} représentent, indépendamment les uns des autres, des radicaux C₁-C₂₀-alkyle non ramifiés, ramifiés, condensés, cycliques ou totalement ou partiellement substitués, des aromatiques et des hétérocycliques substitués ou non substitués,
R₁ₐ et R₂ₐ représentent, indépendamment les uns des autres, des radicaux C₁-C₂₀-alkyle totalement ou partiellement substitués, qui contiennent des halogènes ou correspondent à une des formules 3.3a, 3.3b ou 3.3c 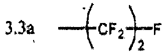 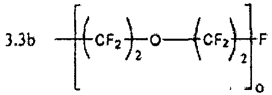 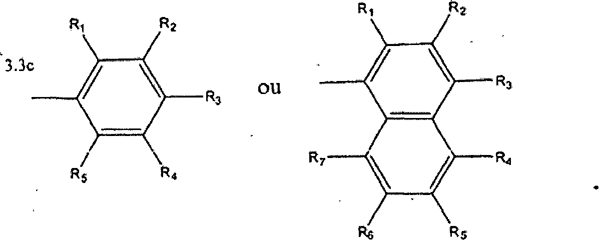 dans lesquelles
dans la formule 3.3b, o = 1-5 et les formules 3.3c sont des systèmes partiellement ou totalement fluorés, R₁ à R₇ représentant, indépendamment l'un de l'autre, H ou F.

2. Couche conductrice de trous selon la revendication 1, les ligands étant choisis dans le groupe acétonate de trifluoroacétyle (tfac), acétonate d'hexafluoroacétyle (hfac) et 3,5-octanedionate de 6,6,7,7,8,8,8-heptafluoro-2,2-diméthyle (fod).

3. Utilisation d'une couche conductrice de trous selon l'une quelconque des revendications précédentes 1 à 2, dans un composant électronique organique.

4. Composant électronique organique présentant une couche conductrice de trous dopée, la substance de dopage comprenant un complexe de métal de transition qui est mononucléaire et quadratique plan et qui présente les formules suivantes : 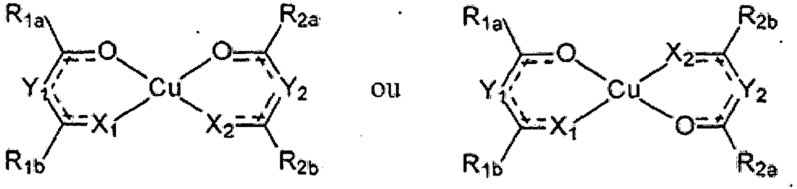 dans lesquelles :
Y₁, Y₂ représentent, indépendamment l'un de l'autre, N, C-R ou CH,
X₁ et X₂ représentent, indépendamment l'un de l'autre, O ou N-R,
R, R_{1b} et R_{2b} représentent, indépendamment les uns des autres, des radicaux C₁-C₂₀-alkyle non ramifiés, ramifiés, condensés, cycliques ou totalement ou partiellement substitués, des aromatiques et des hétérocycliques substitués ou non substitués,
R₁ₐ et R₂ₐ représentent, indépendamment les uns des autres, des radicaux C₁-C₂₀-alkyle totalement ou partiellement substitués, qui contiennent des halogènes ou correspondent à une des formules 3.3a, 3.3b ou 3.3c 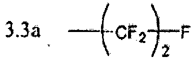 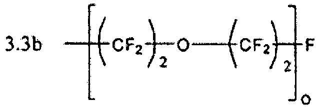 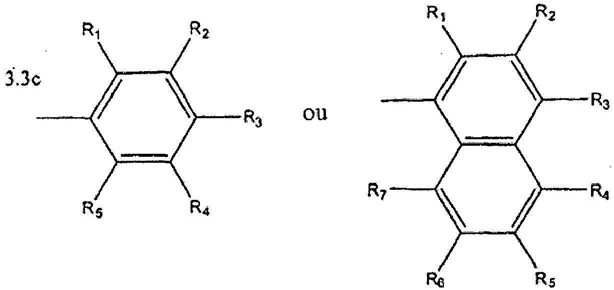 dans lesquelles
dans la formule 3.3b, o = 1-5 et les formules 3.3c sont des systèmes partiellement ou totalement fluorés, R₁ à R₇ représentant, indépendamment l'un de l'autre, H ou F.

5. Composant selon la revendication 4, le composant étant un composant auto-émetteur.
